# EUROPEAN PATENT SPECIFICATION

(11) **EP 4 327 358 B1**
(45) Date of publication and mention of the grant of the patent: **05.11.2025**
(21) Application number: 22853935.9
(22) Date of filing: 05.08.2022
(51) Int. Cl.: H01L 23/498, H01L 23/15

(54) **DEVICE PACKAGING SUBSTRATE, MANUFACTURING METHOD, AND DEVICE PACKAGE**
VORRICHTUNGSVERPACKUNGSSUBSTRAT, HERSTELLUNGSVERFAHREN UND VORRICHTUNGSVERPACKUNG
SUBSTRAT DE BOÎTIER DE DISPOSITIF, SON PROCÉDÉ DE PRODUCTION, ET BOÎTIER DE DISPOSITIF LE COMPRENANT

(30) Priority: 06.08.2021 US 202163230118 P
(43) Date of publication of application: 28.02.2024
(73) Proprietor: Absolics Inc., Covington, GA 30014 (US)
(72) Inventor: KIM, Sungjin, Suwanee, GA 30024 (US)
(74) Representative: BCKIP Part mbB
(86) International application number: PCT/US2022/039508
(87) International publication number: WO 2023/014934

(56) References cited:
- EP-A1- 3 723 459
- US-A1- 2002 105 082
- US-A1- 2002 105 082
- US-A1- 2004 256 731
- US-A1- 2009 212 418
- US-A1- 2013 334 703
- US-A1- 2015 179 560
- US-A1- 2015 380 377
- US-A1- 2020 194 391
- US-A1- 2021 118 860
- US-A1- 2021 134 728
- US-B2- 10 692 820
- KOLEDINTSEVA MARINA Y ET AL: "Improved Experiment-Based Technique to Characterize Dielectric Properties of Printed Circuit Boards", IEEE TRANSACTIONS ON ELECTROMAGNETIC COMPATIBILITY, IEEE SERVICE CENTER , NEW YORK , NY, US, vol. 56, no. 6, 1 December 2014 (2014-12-01), pages 1559 - 1566, XP011567467, ISSN: 0018-9375, [retrieved on 20141211], DOI: 10.1109/TEMC.2014.2317812
- ANONYMOUS: "How Interconnects Work: Modeling Conductor Loss and Dispersionl", SIGNAL INTEGRITY JOURNAL, 21 August 2016 (2016-08-21), XP093040361, Retrieved from the Internet <URL:https://www.signalintegrityjournal.com/articles/25-how-interconnects-work-modeling-conductor-loss-and-dispersion> [retrieved on 20230419]
- ANONYMOUS: "How Interconnects Work: Modeling Conductor Loss and Dispersionl", SIGNAL INTEGRITY JOURNAL, 21 August 2016 (2016-08-21), XP093040361, Retrieved from the Internet <URL:https://www.signalintegrityjournal.com/articles/25-how-interconnects-work-modeling-conductor-loss-and-dispersion> [retrieved on 20230419]

## Description

### BACKGROUND

### 1. Field

The following description relates to a device packaging substrate, a manufacturing method for the same, and device packaging comprising the same.

### 2. Description of Related Art

In the manufacturing processes for electronic components, front-end (FE) processes may implement circuits on semiconductor wafers, back-end (BE) processes may assemble wafers into usable conditions for real products. Packaging processes may be included in the back-end processes.

Semiconductor, semiconductor packaging, semiconductor fabrication, and software technologies may be considered as four core technologies in the semiconductor industry that have enabled the recent rapid development of electronic products. Semiconductor technology has advanced in various areas, including sub-micro nanoscale line widths, more than 10 million cells, high-speed operation, and heat dissipation, but may not be supported by complete packaging technology. Thus, the electrical performance of semiconductors is often determined by packaging technology and resulting electrical connections rather than by the performance of semiconductor technology itself.

Dielectric materials may be implemented for redistribution lines of packaging substrates to distinguish different electrically conductive layers from each other. Additionally, holes are formed in the dielectric material layers, and blind vias to connect the two or more electrically conductive layers disposed on above and below, may be used in a plurality number.

A method of increasing the surface roughness of the electrically conductive layers has been used to improve the adhesive strength between the dielectric material layers and the electrically conductive layers. The influence of the surface roughness on the electronic properties of electrically conductive layers is discussed in DOI: 10.1109/TEMC.2014.2317812 and in "How Interconnects Work: Modeling Conductor Loss and Dispersionl", Signal Integrity Journal, 21 August 2016 (2016-08-21).

Document US 2015 / 0 179 560 A1 discloses a wiring substrate comprising first and second wiring structures. The first wiring structure includes a core substrate, first and second insulation layers each formed from a thermosetting insulative resin including a reinforcement material, and a via wire formed in the first insulation layer. The second wiring structure includes a wiring layer formed on upper surfaces of the first insulation layer and the via wire, an insulation layer formed on the upper surface of the first insulation layer and an uppermost wiring layer including a pad used to electrically connect a semiconductor chip and the wiring layer. An outermost insulation layer stacked on a lower surface of the second insulation layer that exposes a portion of a lowermost wiring layer stacked on the lower surface of the second insulation layer as an external connection pad. The second wiring structure has a higher wiring density than the first wiring structure. Similar wiring substrates are discussed in EP3723459 A1, US2013 / 334703 A1, and US2004 / 256731 A1.

### SUMMARY

This Summary is provided to introduce a selection of concepts in a simplified form that is further described below in the Detailed Description. This Summary is not intended to identify key features or essential features of the claimed subject matter, nor is it intended to be used as an aid in determining the scope of the claimed subject matter.

The present invention provides an electronic packaging substrate in accordance with claim 1, a manufacturing method for a substrate for electronic element packaging with a patterned metal layer in accordance with claim 11, and an electronic element package in accordance with claim 15. According to the present invention, an electronic element packaging substrate includes a glass substrate including a through-hole; and an upper redistribution layer disposed on a first surface of the glass substrate, wherein the upper redistribution layer comprises wires disposed in an insulating material of the upper redistribution layer, and the upper redistribution layer comprises a first upper redistribution layer and a second upper redistribution layer, the first upper redistribution layer comprises a first wire of a first predetermined pattern and a first thickness, and a first blind via configured to connect wires disposed above and below the first blind via to each other, the second upper redistribution layer comprises a second wire of a second predetermined pattern and a second thickness, and a second blind via configured to connect wires disposed above and below the second blind via to each other, the first thickness is less than the second thickness, w1p is a length from a roughness peak of a first side surface of the first wire to a roughness peak of a second side surface in a cross section of the first wire, w1v is a length from a roughness valley of the first side surface of the first wire to a roughness valley of the second side surface in the cross section of the first wire, and a length ratio of the length w1v based on the length w1p is 0.8 µm to 1.0 µm.

The first wire may be configured to have a first surface roughness value, and the first surface roughness value at the first side surface of the first wire is 200 nm or less.

A ratio of the first thickness based on the second thickness may be 0.7 or less.

The first thickness may be a width of the first upper redistribution layer, and the second thickness is a width of the second upper redistribution layer, the first thickness is less than the second thickness, and the first thickness is less than 5 µm.

The first wire may be configured to have a cross-sectional surface roughness value, and the cross-sectional surface roughness value at the first side surface of the first wire is 20 nm or less.

An adhesive strength between the insulating material and one of the wires disposed in the insulating material may be 200 gf to 800 gf.

The first wire may include copper with a particle-type grain, and the copper is configured to have a grain size of 40 nm or less.

A primer layer may be disposed between the wires disposed in the insulating material and the insulating material.

The insulating material may include a polymer resin and an inorganic particle, a polysilane layer may be disposed between the wires disposed in the insulating material and the insulating material, and the polysilane layer may connect the surfaces of the wires disposed in the insulating material; and the polymer resin or the inorganic particle, by chemical bonding.

A surface etching process may not be applied to the first wire.

In a general aspect, a manufacturing method for a substrate for electronic element packaging with a patterned metal layer, the method includes a first operation of preparing a glass substrate where a through-hole is disposed; a second operation of forming a second upper redistribution layer on the glass substrate, and a third operation of forming a first upper redistribution layer on the second upper redistribution layer, wherein the first upper redistribution layer comprises a first wire of a first predetermined pattern and a first thickness, and the second upper redistribution layer comprises a second wire with a second predetermined pattern and a second thickness, the first operation includes: a first sub-operation operation of forming the first wire with the first predetermined pattern and the first thickness by a plating process; a second sub-operation of treating primer to a surface of the first wire; and a third sub-operation of filling an insulating material in spaces between each of the first wires, the first thickness is less than the second thickness, and w1p is a length from a roughness peak of a first side surface of the first wire to a roughness peak of a second side surface in a cross section of the first wire, w1v is a length from a roughness valley of the first side surface of the first wire to a roughness valley of the second side surface in the cross section of the first wire, and a length ratio of the w1v based on the w1p is 0.8 µm to 1.0 µm.

An etching process may not be performed on surfaces of the wires to increase surface roughness of the wires.

The first wire is a copper wire that may not contain a copper of column-type grain.

A primer treatment in the second sub-operation is performed with an imidazole compound or a silane compound.

An electronic element package may include the substrate of claim 1; and an element mounted on the substrate for packaging.

Other features and aspects will be apparent from the following detailed description, the drawings, and the claims.

### BRIEF DESCRIPTION OF DRAWINGS

FIG. 1 is a perspective view illustrating an example electronic element package, in accordance with one or more embodiments.
FIG. 2 is a perspective view illustrating a substrate for an example electronic element packaging, in accordance with one or more embodiments.
FIG. 3 is a cross-sectional view illustrating a part of the cross-section which is taken along line A-A' of FIG. 2.
FIG. 4 is a detailed view of area "U" of FIG. 3 (Top left "A." is an image of an example sample with a surface roughness Ry of 200 nm or less, and bottom left "B." is an image of a comparative example sample with a Ry of 2000 to 3000 nm),
FIG. 5A is an enlarged view of area "G" of FIG. 4, which is a conceptual view illustrating a wire with a low surface roughness, by a cross-section thereof,
FIG. 5B is an enlarged view of area "G" of FIG. 4, which is a conceptual view illustrating a wire with a high surface roughness, by a cross-section thereof,
FIG. 6A is a conceptual view illustrating a manufacturing process for a wire with a particle-type grain, by a cross-section thereof, and
FIG. 6B is a conceptual view illustrating a wire with a column-type grain, by a cross-section thereof.

Throughout the drawings and the detailed description, the same reference numerals may refer to the same, or like, elements. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known, after an understanding of the disclosure of this application, may be omitted for increased clarity and conciseness, noting that omissions of features and their descriptions are also not intended to be admissions of their general knowledge.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

Although terms such as "first," "second," and "third" may be used herein to describe various members, components, regions, layers, or sections, these members, components, regions, layers, or sections are not to be limited by these terms. Rather, these terms are only used to distinguish one member, component, region, layer, or section from another member, component, region, layer, or section. Thus, a first member, component, region, layer, or section referred to in examples described herein may also be referred to as a second member, component, region, layer, or section without departing from the teachings of the examples.

Throughout the specification, when an element, such as a layer, region, or substrate, is described as being "on," "connected to," or "coupled to" another element, it may be directly "on," "connected to," or "coupled to" the other element, or there may be one or more other elements intervening therebetween. In contrast, when an element is described as being "directly on," "directly connected to," or "directly coupled to" another element, there can be no other elements intervening therebetween. Likewise, expressions, for example, "between" and "immediately between" and "adjacent to" and "immediately adjacent to" may also be construed as described in the foregoing.

The terminology used herein is for the purpose of describing particular examples only, and is not to be used to limit the disclosure. As used herein, the singular forms "a," "an," and "the" are intended to include the plural forms as well, unless the context clearly indicates otherwise. As used herein, the term "and/or" includes any one and any combination of any two or more of the associated listed items. As used herein, the terms "include," "comprise," and "have" specify the presence of stated features, numbers, operations, elements, components, and/or combinations thereof, but do not preclude the presence or addition of one or more other features, numbers, operations, elements, components, and/or combinations thereof. The use of the term "may" herein with respect to an example or embodiment (for example, as to what an example or embodiment may include or implement) means that at least one example or embodiment exists where such a feature is included or implemented, while all examples are not limited thereto.

Throughout the present specification, "B being disposed on A" means that B is disposed in direct contact with A or disposed over A with another layer or structure interposed therebetween and thus should not be interpreted as being limited to B being disposed in direct contact with A.

Unless otherwise defined, all terms, including technical and scientific terms, used herein have the same meaning as commonly understood by one of ordinary skill in the art to which this disclosure pertains consistent with and after an understanding of the present disclosure. Terms, such as those defined in commonly used dictionaries, are to be interpreted as having a meaning that is consistent with their meaning in the context of the relevant art and the present disclosure, and are not to be interpreted in an idealized or overly formal sense unless expressly so defined herein.

In the one or more examples, the term "high frequency" refers to a frequency of about 1 GHz to about 300 GHz, specifically a frequency of about 1 GHz to about 30 GHz or a frequency of about 1 GHz to about 15 GHz.

In the one or more examples, the term "fine line" refers to a line with a width of 5 µm or less, for example, a line with a width of 1 to 4 µm or less, unless otherwise specified.

One or more examples relate to a substrate or a device packaging substrate for electronic element packaging, which can embody finer wire widths, transmit signals with low resistance, and can provide a compact package, a manufacturing method for the same, an electronic element package comprising the same.

There has been a growing interest in the use of high frequency power to elevate a rate and an amount of signal transmission. The development of high frequency semiconductor elements inevitably leads to an increasing market demand for packaging substrates to which high frequencies can be applied.

When applying high frequency power to a package, it may be difficult to use a substrate with semiconductor properties such as a silicon substrate (which can bring a significant power loss due to occurring parasitic elements, and the like), and a strong skin effect occurs in wires.

Redistribution lines may be arranged in packaging substrates. With the trend toward smaller and thinner semiconductors and/or semiconductor packages, the sizes of wires (or electrically conductive layers, for example, copper lines) and intervals therebetween in packaging substrates have become smaller.

The redistribution lines are manufactured by repeating a series of processes in which insulating layers and electrically conductive layers are formed and removed, respectively. As a result, the redistribution lines may be formed in a structure in which the wires (electrically conductive layers) are embedded in a predetermined pattern in the insulating material.

A sufficient adhesive strength to the insulating material in the typical redistribution lines may be ensured by increasing the surface roughness of the electrically conductive layer. The increased surface roughness leads to an increase in contact area and an improvement in adhesive strength between the electrically conductive layer and the insulating material due to the anchoring effect. For example, the roughness of copper lines may be improved by etching the surfaces of the copper lines.

In a typical wire with a sufficiently large cross-section, rough and irregular shapes at the edges of the cross-section, which are formed by a surface roughness, result in an insignificant increase in resistance and effectively improve the adhesive strength at the interface. In contrast, in a wire with a fine line, they may result in an excessive increase in resistance and may adversely affect and impede the flow of electric current. Additionally, when high frequency is applied to it, the influence of resistance by the surface roughness would be an important factor determining the resistance of the redistribution line.

The one or more examples relate to a substrate for electronic element packaging, and the like, which substantially reduces a power loss even when high frequency power is applied thereto, applying fine line, and avoiding application of a bilayer structure consisting of a supporting substrate and an interposer.

Hereinafter, the one or more examples will be described in more detail.

### A SUBSTRATE FOR ELECTRONIC ELEMENT PACKAGING

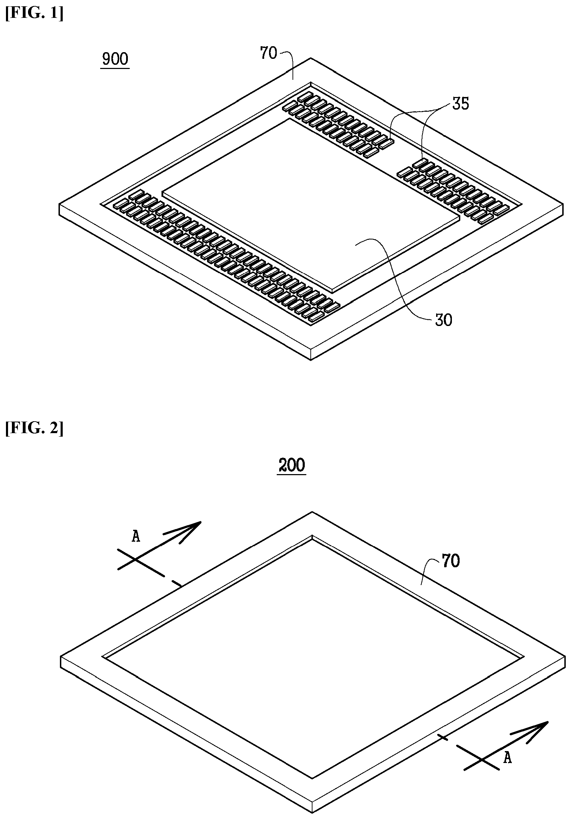

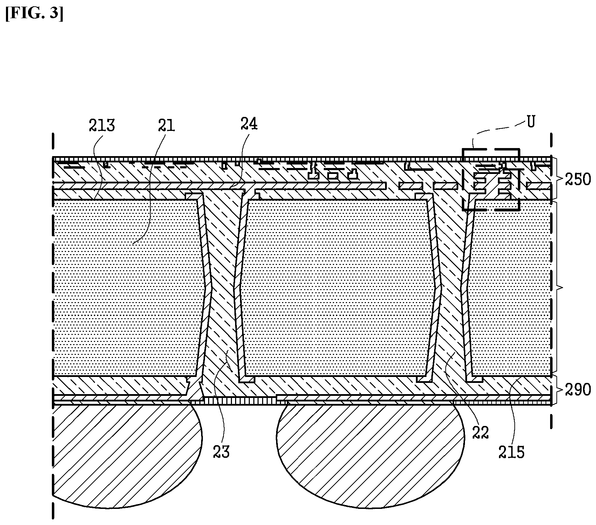

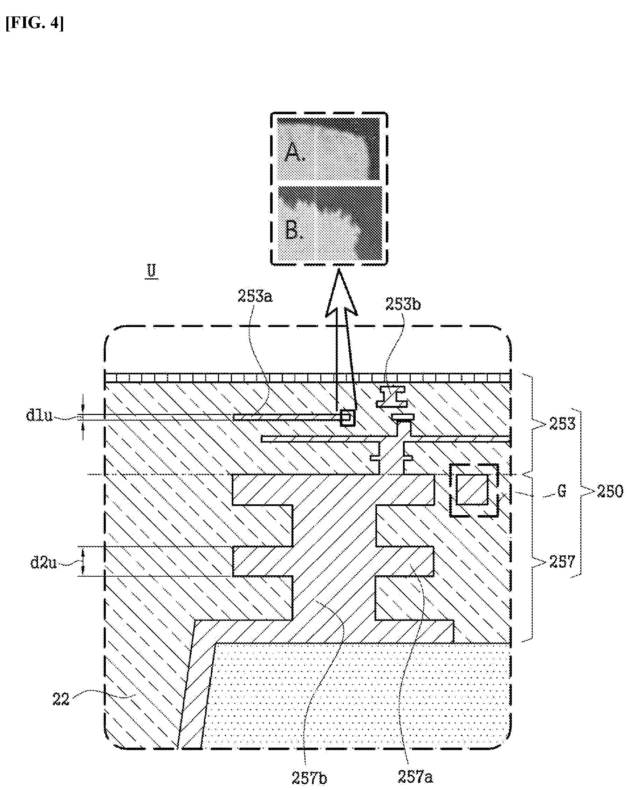

FIG. 2 is a perspective view illustrating a substrate for electronic element packaging, in accordance with one or more embodiments, FIG. 3 is a cross-sectional view illustrating a part of the cross-section which is taken along line A-A' of FIG. 2, and FIG. 4 is a detailed view of area "U" of FIG. 3 (Top left "A." is an image of an example sample with a surface roughness Ry of 200 nm or less, and bottom left "B." is an image of a comparative example sample with a Ry of 2000 to 3000 nm). A packaging substrate 200, according to an example, will be described with reference to FIGS. 2 to 4.

The packaging substrate 200 comprises a glass substrate 21 where a through-hole 23 is disposed; and an upper redistribution layer 250 disposed on one surface 213 of the glass substrate.

The glass substrate 21 may be any suitable one that can be used in the semiconductor field. In a non-limited example, it may be a borosilicate or alkali-free glass substrate but is not limited thereto. As only examples, the glass substrate can be selected from products commercially available from Corning, Schott, AGC, and other manufacturers.

The through-hole 23 is a through glass via (TGV) that penetrates a first surface 213 and a second surface 215 of the glass substrate, and may be formed at predetermined positions in the glass substrate by methods of etching, and the like. The through-hole efficiently connects an element to be mounted on the first surface, and the second surface while allowing the glass substrate to maintain its role in supporting the element. This connection may be an electrical connection that is implemented by wires.

The glass substrate may optionally further comprise a cavity (not illustrated) at a predetermined position. In an example, a passive element may be disposed in the cavity.

The upper redistribution layer 250 comprises wires 24 which have a predetermined pattern and an insulating material 22. The wires 24 may be disposed in the insulating material 22.

The upper redistribution layer 250 comprises a first upper redistribution layer 253 and a second upper redistribution layer 257 respectively disposed above and under each other.

In a non-limiting example, the first upper redistribution layer 253 and the second upper redistribution layer 257 may have different sizes of wires and different diameters of blind vias, and the like.

A ratio of the thickness of the second upper redistribution layer 257 based on the thickness of the first upper redistribution layer 253 may be about 0.8 to about 5 or about 1 to about 3. In this example, the redistribution layers may be manufactured more efficiently.

The first upper redistribution layer 253 comprises a first wire 253a with a predetermined pattern and a thickness d1u, and a first blind via 253b connecting wires disposed above and below the first blind via 253b to each other.

The second upper redistribution layer 257 comprises a second wire 257a with a predetermined pattern and a thickness d2u, and a second blind via 257b connecting wires disposed above and below the second blind via 257b to each other.

Portions other than the wires in the first redistribution layer 253 and the second upper redistribution layer 257 may be filled with insulating material. In this example, the insulating material may appear to be connected as one and thus may not be clearly distinguished from each other in cross section.

In an example, the thickness d1u may be less than the thickness d2u.

In an example, a ratio of the thickness d1u based on the thickness d2u may be about 0.7 or less.

d1u is a width of the first upper redistribution layer 253, and d2u is a width of the second upper redistribution layer 257.

In an example, the width d1u may be less than the width d2u.

In an example, the first wire 253a may be a fine line.

In an example, the width d1u may be less than about 5 µm.

d1u is about 1 µm to about 5 µm.

A first wire 253a may have a property of low surface roughness. Particularly, surface roughness of both side surfaces and/or upper surface thereof may be controlled to a low level.

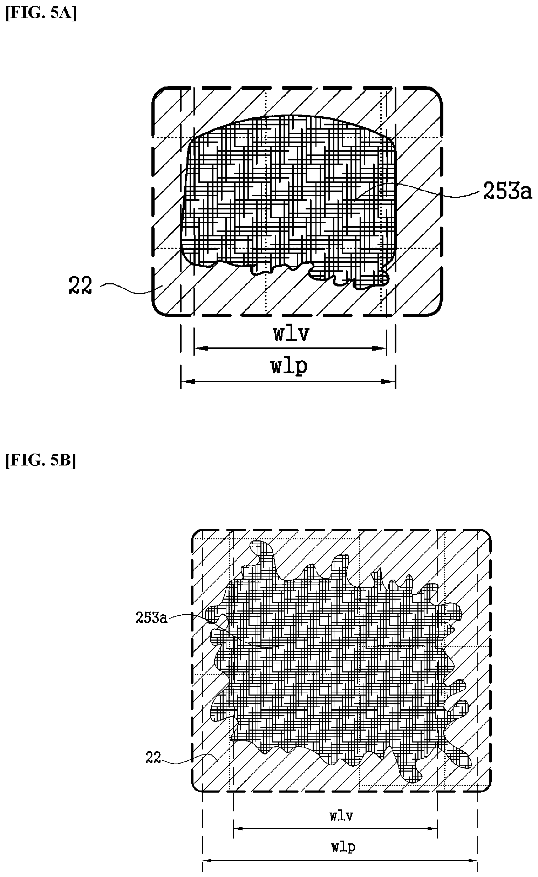

FIG. 5A is a conceptual view illustrating a wire with a low surface roughness, by a cross-section thereof, and FIG. 5B is a conceptual view illustrating a wire with a high surface roughness, by a cross-section thereof.

Referring to FIGS. 5A and 5B, the first wire 253a may have surfaces whose heights are substantially different (*i.e.,* uneven surfaces). The wire can be conceptually expressed as a straight line but indeed it may not be completely smooth or flat in the strict sense. In an example, the first wire illustrated in FIG. 5B may have a surface roughness Ry of about 2,000 nm to about 3,000 nm.

There are various surface roughness R parameters, comprising Ra, Rp, Rv, and Ry, according to the measurement standard. Typically, the surface roughness means the arithmetic mean roughness, Ra. Within a reference length, the maximum valley depth from the mean line to the valley floor line, the maximum peak height from the mean line to the peak line, and the maximum height roughness from the lowest point to the highest point are referred to as Rv, Rp, and Ry, respectively. Ry is the sum of Rv and Rp.

The surface roughness of a wire can be measured by a method other than the general method of measuring roughness. The roughness of a wire can be easily measured using a roughness tester during its production, but the surface roughness of a wire embedded in an insulating material is actually difficult to measure using a roughness tester. It is also difficult to set a reference length. Thus, for a wire used in a packaging substrate, its cross section is observed, and the roughness peak and valley values are determined along the boundary between an insulating material and the wire.

A length from a roughness peak of one side surface of the first wire to a roughness peak of the opposite side surface in the cross section of the first wire 253a is defined as w1p, and a length from a roughness valley of one side surface to a roughness valley of the opposite side surface in the cross section of the first wire 253a is defined as w1v (Referring to FIGS. 5A and 5B).

In an example, the one side surface and the opposite side surface may face each other.

An element disposed between an imaginary straight line tangent to w1p and an imaginary straight line tangent to w1v, is an element where a peak or valley is formed on a surface of the wire in the direction substantially perpendicular to the direction of current flow. The migration of charges in this element may not produce a current flow. Accordingly, a current substantially flows through an inner part of the wire based on the imaginary straight line tangent to w1v.

As the wire becomes finer, the proportion of portions where the roughness is formed in the cross section of the wire, increases. If the surface roughness of the wire whose cross-sectional area has already been reduced as the wire becomes finer, increases, the area through which a current can substantially flow decreases. This is a serious problem, unlike in a relatively wide wire. In order to form mechanical anchoring sites, it may be beneficial to adjust the surface roughness Ry to about 2 µm to about 3 µm. For example, it is assumed that the width of the wire is about 6 µm. If the surface roughness Ry of about 2 µm to about 3 µm is respectively formed on both side surfaces of the wire, the width of the wire through which a current can substantially flow is about 0 µm to about 2 µm which is except the portions where the valleys are formed on both side surfaces. This results in excessively high resistance of the wire.

When AC power is applied, the highest current density may be observed at the skin of the wire which is corresponding to the edge of the wire, when observed in the cross section thereof. This is called the skin effect, and it may be greater when a higher frequency is applied.

When a wire having mechanical anchoring sites is used in a packaging substrate to which high frequency power is applied, the greater skin effect causes a higher resistance, leading to problems such as inefficient signal transmission and poor durability.

Accordingly, the height (size) from the roughness peak to the roughness valley on each of both side surfaces of the wire is an important parameter in the wire, particularly a fine line as the wire.

In one or more examples, a length ratio of the w1v based on the w1p in the first wire 253a is about 0.8 to about 1.0. Specifically, this ratio may be about 0.85 to about 1.0, about 0.9 to about 1.0 or about 0.94 to about 1.0. When the ratio of the wire is in the range defined above, a smoother flow of current is ensured and more efficient signal transmission is achieved, particularly when high frequency power is applied.

In one or more examples, the features on both side surfaces may be similarly applied to the upper and lower surfaces of the first wire 253a when viewed in cross-section. Specifically, the length from the roughness peak of the upper surface to the roughness peak of the lower surface in the cross section of the first wire 253a is defined as w1p', and the length from the roughness valley of the upper surface to the roughness valley of the lower surface in the cross section of the first wire 253a is defined as w1v'.

A length ratio of the w1v' based on the w1p' in the first wire 253a is about 0.8 to about 1.0. Specifically, the length ratio of the w1v' based on the w1p' may be about 0.85 to about 1.0, about 0.9 to about 1.0 or about 0.94 to about 1.0. When the ratio of the wire is in the range defined above, a smoother flow of current is ensured and more efficient signal transmission is achieved, particularly when high frequency power is applied.

For reference, although the lower surface of the sample for measurement in FIG. 5A is illustrated to be uneven (to have a high roughness) as surface roughness thereof is not controlled to be smooth, it is to be understood that a sample having smooth surfaces also can be produced.

The first wire 253a may have a value of Ry1, which is a surface roughness Ry observed in cross-section thereof.

The first wire 253a may have the Ry1 value of about 200 nm or less at one side surface thereof.

The first wire 253a may have the Ry1 value of about 200 nm or less at least two side surfaces thereof.

The first wire 253a may have the Ry1 value of about 200 nm or less at four side surfaces thereof.

The Ry1 value may be more than about 0 nm and 180 nm or less, about 2 nm to about 150 nm, or about 5 nm to about 100 nm.

The first wire 253a has a value of Ra1, which is a surface roughness Ra observed in cross-section thereof.

The first wire 253a may have the Ra1 value of about 20 nm or less at one side surface thereof.

The first wire 253a may have the Ra1 value of about 20 nm or less at least two side surfaces thereof.

The first wire 253a may have the Ra1 value of about 20 nm or less at four side surfaces thereof.

The Ra1 value may be more than about 0 nm and about 20 nm or less, about 1 nm to about 18 nm, or about 2 nm to about 15 nm.

It is preferable that the surface of the first wire 253a is not substantially etched.

In this example, the wire may be substantially smooth over the entire surface.

The surface properties of the wire can be obtained by methods such as controlling a grain size during plating, or without surface etching of the wire. A detailed process for manufacturing will be described below.

Other wires such as the second wire 257a may also have the same surface properties as described for the first wire 253a.

The wire having the properties of surface roughness described above may not have mechanical anchoring sites, unlike typical applications. Thus, a primer layer (not illustrated) may be formed between each of the wires 24 and the insulating material 22 surrounding them, to ensure sufficient adhesive strength.

The primer layer may be a silane or polysilane layer. The primer layer may not be substantially distinguished as a separate layer when observed under a microscope.

The insulating material 22 may comprise a polymer resin and inorganic particles.

The inorganic particles may comprise, for example, silica particles but are not limited thereto. For example, each of the inorganic particles may have an average diameter of 100 nm or less, or 80 nm or less. The inorganic particles may have an average diameter of 20 nm or more. A mixture of inorganic particles with different diameters may also be used.

The polymer resin may be a UV-curable epoxy resin but is not limited thereto. For example, the epoxy resin may be used in combination with a phenolic curing agent, the epoxy resin may be used in combination with a cyanate ester or the epoxy resin may be used in combination with a phenolic ester curing agent.

The insulating material may be inorganic particles-dispersed state in an uncured or semi-cured polymer resin. The presence of inorganic particles with various diameters in a predetermined proportion in the insulating material ensures a sufficient insulating effect. The insulating material is infiltrated into gaps due to its high flowability to substantially prevent the formation of voids in the redistribution layer and is then fixed when the polymer resin is cured.

The insulating material may be an Ajinomoto build-up film (ABF) but is not limited as long as it can be used to form the redistribution layer.

The insulating material may be applied by methods such as disposing a build-up film on the wire and pressure-sensitive laminating on it, but is not limited thereto.

The polysilane layer connects the surface of the wire and the insulating material by chemical bonding. In an example, when the wire includes copper, the copper may chemically react with the silane, or oxygen on the copper surface may chemically react with the silane (-Cu-O-Si-). Due to this, substantially sufficient adhesion so that being detached, and the like to not occur, can be ensured even during driving of electronic element even without forming mechanical anchoring sites on the surface of the wire.

The polysilane layer connects the surface of the wire and the functional groups of the polymer or the surface of the wire and the surface of the inorganic particles by chemical bonding.

The adhesive strength between one of the wires 24 and the insulating material 22 may be about 200 gf or more.

The adhesive strength between one of the wires 24 and the insulating material 22 may be about 200 gf to about 800 gf.

The adhesive strength is a value measured when the primer is used and may be about 2 times or more or about 2 to about 8 times higher than that measured when the wire directly adheres to the insulating material without using the primer.

Thermal expansion coefficient may differ depending on the type of material. The temperature of a package inevitably rises and falls repeatedly during driving of an electronic element. The different thermal expansion coefficient may cause forces to act in substantially different directions at the interface between the insulating material and the electrically conductive layer. The repeated forces may cause separation at the interface, which may be responsible for defects such as increased resistance during signal transmission, and detachment.

In one or more examples, the wires and the insulating material may have substantially the similar coefficient of thermal expansion.

A thermal expansion coefficient ratio of the wires 24 and insulating material 22 may be about 0.7 to about 1.2, based on the thermal expansion coefficient of the wires 24. The ratio may be 0.8 to 1.1, based on the thermal expansion coefficient of the wires 24. The ratio may be 0.95 to 1.05, based on the thermal expansion coefficient of the wires 24. Within this narrow range of thermal expansion coefficient ratio, the occurrence of defects in an electronic element package can be substantially reduced.

The wires 24 may have a thermal expansion coefficient of 15 to 19 ppm/°C or may have a thermal expansion coefficient of 16 to 18.5 ppm/°C at 25 °C.

The insulating material 22 may have a thermal expansion coefficient of 16 to 30 ppm/°C at 25°C.

The first wire 253a may comprise a copper with a particle-type grain.

The first wire 253a may comprise a copper wire.

The copper wire may be a metal comprising a copper with a particle-type grain.

The copper wire may be a metal copper or a copper-containing alloy.

The copper may have a grain size of about 40 nm or less or about 20 nm to about 30 nm.

The wires 24 may be a copper foil when its size is required to be large. As each of the wires 24 becomes a fine line, it is often produced by electroplating.

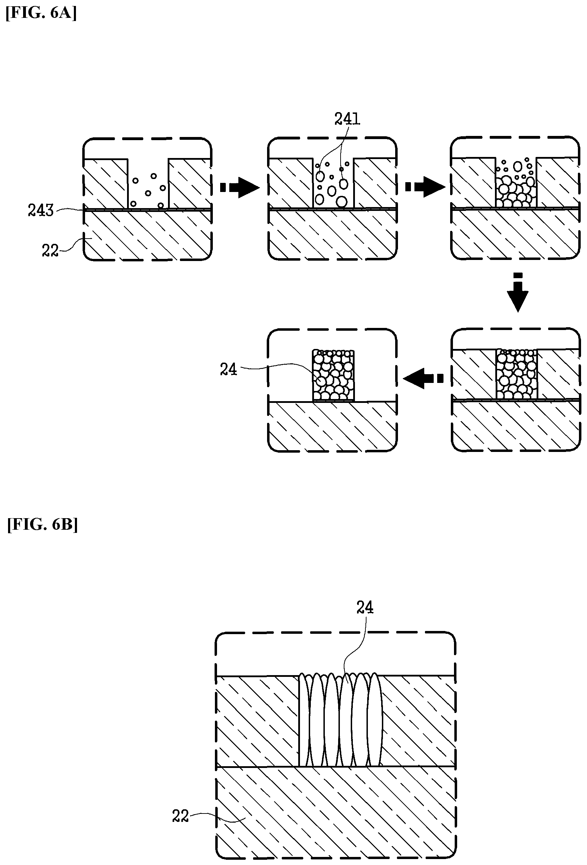

FIG. 6A is a conceptual view illustrating a manufacturing process for a wire with a particle-type grain, in a cross-section.

Referring to FIG. 6A and explaining the wire with a copper as a reference, a sample with an insulating material, a wire material, and a seed layer 243 is placed in an electrolyte, followed by plating process. The seed layer may be, for example, a titanium-sputtered layer but is not limited thereto. The wire material 241 (*e.g*., copper) grows into a particle-shape and fills voids in the insulating material. And it has overall particle-type grains, although its particle sizes are different to a greater or lesser extent.

FIG. 6B is a conceptual view illustrating a wire with a column-type grain, in a cross-section. For example, when the wires 24 are prepared by using copper foils, the structure of the wires 24 embedded in an insulating material 22, may be similar to the structure of FIG. 6A, except that the shape of grain is column-type, instead of particle-type.

The wire with a particle-type grain can be made finer than the wire with a column-type grain.

The surface of the wire may be etched to form mechanical anchoring sites. The etching is performed with an acid component. The etched surface morphology varies depending on the type of the acid. For example, when the acid is formic acid, the grain boundaries are etched, resulting in high surface roughness.

In one or more examples, the wires 24, particularly fine lines, may be prepared by a process of forming a primer layer in the same manner described above, except that such surface treatment is not performed. A detailed manufacturing process will be described below.

The packaging substrate 200 may further comprise a lower layer 290 (FIG. 3) under the other surface 215 (FIG. 3).

The lower layer 290 may comprise a lower redistribution line (not illustrated).

The lower redistribution line comprises a lower wire (not illustrated) with a predetermined pattern and a predetermined thickness, and a lower blind via (not illustrated) connecting wires disposed above and under to each other.

The packaging substrate 200 may comprise an upper insulating layer disposed on the upper surface of the upper redistribution layer. The upper insulating layer may have bumps (not illustrated) through which signals can be transmitted to an element 30.

The packaging substrate 200 may comprise a lower insulating layer disposed under the lower layer. The lower insulating layer may have bumps (not illustrated) through which signals from a main board, and the like can be received and signals from the element may be transmitted.

The packaging substrate 200 may further comprise a lid 70 (FIG. 1) disposed on the upper surface of the upper redistribution layer. The lid 70 may help dissipation of heat generated from the element or the substrate to the outside and can serve to protect the glass substrate 21 from external impacts. Holes or sinking parts to which pins can be coupled may be formed at one side thereof. These can increase convenience when the packaging substrate is fixed during or after its production.

The packaging substrate 200 may comprise a power transmission element 35 disposed on its surface or inside thereof. The power transmission element may be, for example, a passive element, but not limited thereto. The power transmission element may be a capacitor, for example, an aluminum capacitor or a multi-layer ceramic capacitor (MLCC), but not limited thereto.

The power transmission element may be disposed on the upper redistribution layer. The power transmission element may be disposed in a cavity formed in the glass substrate. The power transmission element may be disposed in a cavity formed in the upper redistribution layer.

### AN ELECTRONIC ELEMENT PACKAGE

FIG. 1 is a perspective view illustrating an electronic element package, in accordance with one or more embodiments.

An electronic element package 900, in accordance with one or more embodiments, comprises a substrate 200 for electronic element packaging; and an element 30 mounted on the packaging substrate.

Description for the substrate 200 for electronic element packaging is the same as that described above and is thus omitted.

The element 30 may be, for example, a computing element such as, but not limited to, a CPU or a GPU, or a memory element such as memory chip. The element 30 may be arranged in parallel, or may be stacked with one or more other elements.

The element 30 may be a high frequency semiconductor element. When the high frequency semiconductor element is used in combination with the packaging substrate, parasitic elements do not substantially occur in a high frequency environment, unlike when used in combination with a silicon substrate, achieving high efficiency, and the redistribution line can be made compact in size, unlike when used in combination with a prepreg substrate.

### A MANUFACTURING METHOD FOR A SUBSTRATE FOR ELECTRONIC ELEMENT PACKAGING

A manufacturing method for a substrate for electronic element packaging with a patterned metal layer, in accordance with one or more embodiments, comprises a first operation of preparing a glass substrate 21 where a through-hole 23 is disposed, a second operation of forming a second upper redistribution layer 257 on the glass substrate 21, and a third operation of forming a first upper redistribution layer 253 on the second upper redistribution layer 257.

The first upper redistribution layer 253 comprises a first wire 253a with a predetermined pattern and a thickness d1u.

The second upper redistribution layer 257 comprises a second wire 257a with a predetermined pattern and a thickness d2u.

The first operation may comprise an operation 1-1, or a first sub-operation, of forming a first wire 253a (including an example of forming at least an element) with a predetermined pattern and a thickness d1u by plating; an operation 1-2, or a second sub-operation, of treating primer to a surface of the first wire 253a; and an operation 1-3, or a third sub-operation, of filling an insulating material in spaces between each of the first wires 253a.

Description for the substrate for electronic element packaging, the glass substrate, the through-hole, the wires, and the like comprised in the packaging substrate are the same as those described above and omitted to avoid duplication.

The first wire 253a may be a copper wire substantially not containing a copper of column-type grain.

A primer treatment in the operation 1-2 may be performed using a silane or an imidazole compound.

The silane compound, which is used as a silane coupling agent or containing additional functional group, may be used.

For example, the silane compound may comprise hydrolysable functional group such as a methoxy and/or ethoxy group at one end thereof. In addition, the silane compound may comprise an amino group, vinyl group, epoxy group, methacryloxy group, acryloxy group, ureido group, mercapto group, sulfido group or isocyanate group at the other end thereof.

In an example, the compound used in the primer treatment may comprise imidazole, 3-glycidoxypropyltrimethoxysilane or tetramethyl orthosilicate.

Specifically, the primer treatment may be performed by coating and curing thereof.

The silane compound can be bonded to the surface of the metal and the insulating material (e.g., a polymer compound and inorganic particles) through chemical reactions to improve the adhesive strengths at the interfaces thereof.

Description for them is the same as that described above and omitted to avoid duplication.

The substrate for electronic element packaging, manufacturing method for the same, and electronic element package including the same, of the one or more examples may embody finer wire widths and transmit signals with low resistance.

The substrate for electronic element packaging, manufacturing method for the same, and electronic element package including the same, of the one or more examples can provide an electronic element package in compact size and can be driven with high efficiency even when high frequency power is applied thereto.

## Claims

1. An electronic element packaging substrate (200), comprising:
a glass substrate (21) including a through-hole (23); and
an upper redistribution layer (250) disposed on a first surface (213) of the glass substrate (21),
wherein:
the upper redistribution layer (250) comprises wires (24) disposed in an insulating material (22) of the upper redistribution layer (250), and the upper redistribution layer (250) comprises a first upper redistribution layer (253) and a second upper redistribution layer (257),
the first upper redistribution layer (253) comprises a first wire (253a) of a first predetermined pattern and a first thickness (d1u), and a first blind via (253b) configured to connect wires disposed above and below the first blind via (253b) to each other,
the first thickness (d1u) of the first wire (253a) is about 1 µm to about 5 µm,
the second upper redistribution layer (257) comprises a second wire (257a) of a second predetermined pattern and a second thickness (d2u), and a second blind via (257b) configured to connect wires disposed above and below the second blind via (257b) to each other,
the first thickness (d1u) is less than the second thickness (d2u),
w1p is a length from a roughness peak of a first side surface of the first wire (253a) to a roughness peak of a second side surface in a cross section of the first wire (253a),
w1v is a length from a roughness valley of the first side surface of the first wire (253a) to a roughness valley of the second side surface in the cross section of the first wire (253a), and
a length ratio of the length w1v based on the length w1p is 0.8 to 1.0.

2. The substrate of claim 1, wherein the first wire is configured to have a first surface roughness value, and the first surface roughness value at the first side surface of the first wire is 200 nm or less.

3. The substrate of claim 1, wherein a ratio of the first thickness (d1u) based on the second thickness (d2u) is 0.7 or less.

4. The substrate (200) of claim 1, wherein:
the first thickness (d1u) is a width of the first upper redistribution layer (253),
the second thickness (d2u) is a width of the second upper redistribution layer (257),
the first thickness (d1u) is less than the second thickness (d2u), and
the first thickness (d1u) is less than 5 µm.

5. The substrate (200) of claim 1,
wherein the first wire (253a) is configured to have a cross-sectional surface roughness value, and
wherein the cross-sectional surface roughness value at the first side surface of the first wire (253a) is 20 nm or less.

6. The substrate (200) of claim 1,
wherein an adhesive strength between the insulating material (22) and one of the wires (24) disposed in the insulating material (22) is 200 gf to 800 gf.

7. The substrate (200) of claim 1,
wherein the first wire (253a) comprises copper with a particle-type grain, and
wherein the copper is configured to have a grain size of 40 nm or less.

8. The substrate (200) of claim 1, wherein a primer layer is disposed between the wires (24) disposed in the insulating material (22) and the insulating material (22).

9. The substrate (200) of claim 1,
wherein the insulating material (22) comprises a polymer resin and an inorganic particle,
wherein a polysilane layer is disposed between the wires (24) disposed in the insulating material (22) and the insulating material (22), and
wherein the polysilane layer connects the surfaces of the wires (24) disposed in the insulating material (22); and the polymer resin or the inorganic particle, by chemical bonding.

10. The substrate (200) of claim 1, wherein a surface etching process is not applied to the first wire (253a).

11. A manufacturing method for a substrate (200) for electronic element packaging with a patterned metal layer, the method comprising:
a first operation of preparing a glass substrate (21) where a through-hole (23) is disposed;
a second operation of forming a second upper redistribution layer (257) on the glass substrate (21), and
a third operation of forming a first upper redistribution layer (253) on the second upper redistribution layer (257),
wherein:
the first upper redistribution layer (253) comprises a first wire (253a) of a first predetermined pattern and a first thickness (d1u), and
the second upper redistribution layer (257) comprises a second wire (257a) with a second predetermined pattern and a second thickness (d2u),
the first operation comprises:
a first sub-operation of forming the first wire (253a) with the first predetermined pattern and the first thickness (d1u) by implementing a plating process,
the first thickness (d1u) of the first wire (253a) is about 1 µm to about 5 µm;
a second sub-operation of treating primer to a surface of the first wire (253a); and
a third sub-operation of filling an insulating material in spaces between each of the first wires (253a),
wherein the first thickness (d1u) is less than the second thickness (d2u), and
w1p is a length from a roughness peak of a first side surface of the first wire (253a) to a roughness peak of a second side surface in a cross section of the first wire (253a),
w1v is a length from a roughness valley of the first side surface of the first wire (253a) to a roughness valley of the second side surface in the cross section of the first wire (253a), and
a length ratio of the w1v based on the w1p is 0.8 to 1.0.

12. The manufacturing method of claim 11, wherein an etching process is not performed on surfaces of the wires to increase surface roughness of the wires (24).

13. The manufacturing method of claim 11, wherein the first wire (253a) is a copper wire that does not contain a copper of column-type grain.

14. The manufacturing method of claim 11, wherein, a primer treatment in the second sub-operation is performed with an imidazole compound or a silane compound.

15. An electronic element package (900) comprising:
the substrate (200) of claim 1; and an element mounted on the substrate (200) for packaging.

## Patentansprüche

1. Substrat (200) für die Verpackung elektronischer Bauelemente, umfassend:
ein Glassubstrat (21), das ein Durchgangsloch (23) aufweist; und
eine obere Umverteilungsschicht (250), die auf einer ersten Oberfläche (213) des Glassubstrats (21) angeordnet ist;
wobei:
die obere Umverteilungsschicht (250) Leiterbahnen (24) umfasst, die in einem Isoliermaterial (22) der oberen Umverteilungsschicht (250) angeordnet sind, und die obere Umverteilungsschicht (250) eine erste obere Umverteilungsschicht (253) und eine zweite obere Umverteilungsschicht (257) umfasst,
die erste obere Umverteilungsschicht (253) eine erste Leiterbahn (253a) mit einem ersten vorbestimmten Muster und einer ersten Dicke (d1u) und eine erste blinde Durchkontaktierung (253b), die so konfiguriert ist, dass sie oberhalb und unterhalb der ersten blinden Durchkontaktierung (253b) angeordnete Leiterbahnen miteinander verbindet, umfasst,
die erste Dicke (d1u) der ersten Leiterbahn (253a) ungefähr 1 µm bis ungefähr 5 µm beträgt,
die zweite obere Umverteilungsschicht (257) eine zweite Leiterbahn (257a) mit einem zweiten vorbestimmten Muster und einer zweiten Dicke (d2u) und eine zweite blinde Durchkontaktierung (257b), die so konfiguriert ist, dass sie oberhalb und unterhalb der zweiten blinden Durchkontaktierung (257b) angeordnete Leiterbahnen miteinander verbindet, umfasst,
die erste Dicke (d1u) geringer als die zweite Dicke (d2u) ist,
w1p eine Länge von einer Rauheitsspitze einer ersten Seitenoberfläche der ersten Leiterbahn (253a) bis zu einer Rauheitsspitze einer zweiten Seitenoberfläche in einem Querschnitt der ersten Leiterbahn (253a) ist,
w1v eine Länge von einem Rauheitstal der ersten Seitenoberfläche der ersten Leiterbahn (253a) bis zu einem Rauheitstal der zweiten Seitenoberfläche in dem Querschnitt der ersten Leiterbahn (253a) ist, und ein Längenverhältnis der Länge w1v zu der Länge w1p 0,8 bis 1,0 beträgt.

2. Substrat (200) nach Anspruch 1, wobei die erste Leiterbahn so konfiguriert ist, dass sie einen ersten Oberflächenrauheitswert aufweist, und der erste Oberflächenrauheitswert an der ersten Seitenoberfläche der ersten Leiterbahn 200 nm oder weniger beträgt.

3. Substrat (200) nach Anspruch 1, wobei ein Verhältnis der ersten Dicke (d1u) zu der zweiten Dicke (d2u) 0,7 oder weniger beträgt.

4. Substrat (200) nach Anspruch 1, wobei:
die erste Dicke (d1u) eine Breite der ersten oberen Umverteilungsschicht (253) ist,
die zweite Dicke (d2u) eine Breite der zweiten oberen Umverteilungsschicht (257) ist,
die erste Dicke (d1u) kleiner als die zweite Dicke (d2u) ist, und
die erste Dicke (d1u) kleiner als 5 µm ist.

5. Substrat (200) nach Anspruch 1,
wobei die erste Leiterbahn (253a) so konfiguriert ist, dass sie einen Querschnitts-Oberflächenrauheitswert aufweist, und
wobei der Querschnitts-Oberflächenrauheitswert an der ersten Seitenoberfläche der ersten Leiterbahn (253a) 20 nm oder weniger beträgt.

6. Substrat (200) nach Anspruch 1,
wobei eine Haftfestigkeit zwischen dem Isoliermaterial (22) und einer der in dem Isoliermaterial (22) angeordneten Leiterbahnen (24) 200 gf bis 800 gf beträgt.

7. Substrat (200) nach Anspruch 1,
wobei die erste Leiterbahn (253a) Kupfer mit einer partikelartigen Körnung umfasst, und
wobei das Kupfer so konfiguriert ist, dass es eine Körnungsgröße von 40 nm oder weniger aufweist.

8. Substrat (200) nach Anspruch 1, wobei eine Grundierungsschicht zwischen den in dem Isoliermaterial (22) angeordneten Leiterbahnen (24) und dem Isoliermaterial (22) angeordnet ist.

9. Substrat (200) nach Anspruch 1,
wobei das Isoliermaterial (22) ein Polymerharz und ein anorganisches Teilchen umfasst,
wobei eine Polysilan-Schicht zwischen den in dem Isoliermaterial (22) angeordneten Leiterbahnen (24) und dem Isoliermaterial (22) angeordnet ist, und
wobei die Polysilanschicht die Oberflächen der in dem Isoliermaterial (22) angeordneten Leiterbahnen (24) und dem Polymerharz durch chemische Bindung verbindet.

10. Substrat (200) nach Anspruch 1, wobei auf die erste Leiterbahn (253a) kein Oberflächenätzprozess angewandt wird.

11. Herstellungsverfahren für ein Substrat (200) für die Verpackung elektronischer Bauelemente mit einer gemusterten Metallschicht, wobei das Verfahren umfasst:
einen ersten Vorgang des Vorbereitens eines Glassubstrats (21), in dem ein Durchgangsloch (23) angeordnet ist;
einen zweiten Vorgang des Bildens einer zweiten oberen Umverteilungsschicht (257) auf dem Glassubstrat (21), und
einen dritten Vorgang des Bildens einer ersten oberen Umverteilungsschicht (253) auf der zweiten oberen Umverteilungsschicht (257),
wobei:
die erste obere Umverteilungsschicht (253) eine erste Leiterbahn (253a) mit einem ersten vorbestimmten Muster und einer ersten Dicke (d1u) umfasst, und
die zweite obere Umverteilungsschicht (257) eine zweite Leiterbahn (257a) mit einem zweiten vorbestimmten Muster und einer zweiten Dicke (d2u) umfasst,
der erste Vorgang umfasst:
einen ersten Teilvorgang des Bildens der ersten Leiterbahn (253a) mit dem ersten vorbestimmten Muster und der ersten Dicke (d1u) durch Implementieren eines Beschichtungsprozesses,
wobei die erste Dicke (d1u) der ersten Leiterbahn (253a) ungefähr 1 µm bis ungefähr 5 µm beträgt;
einen zweiten Teilvorgang des Behandelns der Oberfläche der ersten Leiterbahn (253a) mit einer Grundierung; und
einen dritten Teilvorgang des Füllens eines Isoliermaterials in die Zwischenräume zwischen den einzelnen ersten Leiterbahnen (253a),
wobei die erste Dicke (d1u) geringer als die zweite Dicke (d2u) ist, und
w1p eine Länge von einer Rauheitsspitze einer ersten Seitenoberfläche der ersten Leiterbahn (253a) zu einer Rauheitsspitze einer zweiten Seitenoberfläche in einem Querschnitt der ersten Leiterbahn (253a) ist,
w1v eine Länge von einem Rauheitstal der ersten Seitenoberfläche der ersten Leiterbahn (253a) zu einem Rauheitstal der zweiten Seitenoberfläche in dem Querschnitt der ersten Leiterbahn (253a) ist, und
ein Längenverhältnis von w1v zu w1p 0,8 bis 1,0 beträgt.

12. Herstellungsverfahren nach Anspruch 11, wobei auf Oberflächen der Leiterbahnen kein Ätzprozess zur Erhöhung der Oberflächenrauheit der Leiterbahnen (24) durchgeführt wird.

13. Herstellungsverfahren nach Anspruch 11, wobei die erste Leiterbahn (253a) eine Kupferleiterbahn ist, die kein Kupfer mit säulenförmiger Körnung enthält.

14. Herstellungsverfahren nach Anspruch 11, wobei eine Grundierungsbehandlung in dem zweiten Teilvorgang mit einer Imidazolverbindung oder einer Silanverbindung durchgeführt wird.

15. Packung für ein elektronisches Bauelement (900), umfassend:
das Substrat (200) nach Anspruch 1; und ein auf dem Substrat (200) montiertes Element für die Verpackung.

## Revendications

1. Substrat d'emballage de composant électronique (200), comprenant :
un substrat en verre (21) présentant un trou traversant (23) ; et
une couche de redistribution supérieure (250) disposée sur une première surface (213) du substrat en verre (21),
où :
la couche de redistribution supérieure (250) comprend des fils (24) disposés dans un matériau isolant (22) de la couche de redistribution supérieure (250), et la couche de redistribution supérieure (250) comprend une première couche de redistribution supérieure (253) et une deuxième couche de redistribution supérieure (257),
la première couche de redistribution supérieure (253) comprend un premier fil (253a) ayant un premier motif prédéterminé et une première épaisseur (d1u), et un premier trou d'interconnexion borgne (253b) prévu pour relier les uns aux autres des fils disposés au-dessus et en dessous du premier trou borgne (253b),
la première épaisseur (d1u) du premier fil (253a) est comprise entre environ 1 µm et environ 5 µm,
la deuxième couche de redistribution supérieure (257) comprend un deuxième fil (257a) ayant un deuxième motif prédéterminé et une deuxième épaisseur (d2u), et un deuxième trou borgne (257b) prévu pour relier les uns aux autres des fils disposés au-dessus et en dessous du deuxième trou borgne (257b),
la première épaisseur (d1u) est inférieure à la deuxième épaisseur (d2u),
w1p est la longueur entre un pic de rugosité d'une première surface latérale du premier fil (253a) et un pic de rugosité d'une deuxième surface latérale dans la section transversale du premier fil (253a),
w1v est la longueur entre un creux de rugosité de la première surface latérale du premier fil (253a) et un creux de rugosité de la deuxième surface latérale dans la section transversale du premier fil (253a), et
le rapport entre la longueur w1v et la longueur w1p est compris entre 0,8 et 1,0.

2. Substrat selon la revendication 1, où le premier fil est prévu de manière à présenter une première valeur de rugosité de surface, et où la première valeur de rugosité de surface sur la première surface latérale du premier fil est inférieure ou égale à 200 nm.

3. Substrat selon la revendication 1, où le rapport entre la première épaisseur (d1u) et la deuxième épaisseur (d2u) est inférieur ou égal à 0,7.

4. Substrat (200) selon la revendication 1, où :
la première épaisseur (d1u) est la largeur de la première couche de redistribution supérieure (253),
la deuxième épaisseur (d2u) est la largeur de la deuxième couche de redistribution supérieure (257),
la première épaisseur (d1u) est inférieure à la deuxième épaisseur (d2u), et
la première épaisseur (d1u) est inférieure à 5 µm.

5. Substrat (200) selon la revendication 1,
où le premier fil (253a) est prévu de manière à présenter une valeur de rugosité de surface en coupe transversale, et
où la valeur de rugosité de surface en coupe transversale sur la première surface latérale du premier fil (253a) est inférieure ou égale à 20 nm.

6. Substrat (200) selon la revendication 1,
où la force adhésive entre le matériau isolant (22) et l'un des fils (24) disposés dans le matériau isolant (22) est comprise entre 200 gf et 800 gf.

7. Substrat (200) selon la revendication 1,
où le premier fil (253a) comprend du cuivre avec un grain de type particulaire, et où le cuivre est prévu pour avoir une taille de grain inférieure ou égale à 40 nm.

8. Substrat (200) selon la revendication 1, où une couche primaire est disposée entre les fils (24) disposés dans le matériau isolant (22) et le matériau isolant (22).

9. Substrat (200) selon la revendication 1,
où le matériau isolant (22) comprend une résine polymère et une particule inorganique,
une couche de polysilane étant disposée entre les fils (24) disposés dans le matériau isolant (22) et le matériau isolant (22), et
où la couche de polysilane relie les surfaces des fils (24) disposés dans le matériau isolant (22) et la résine polymère ou la particule inorganique, par liaison chimique.

10. Substrat (200) selon la revendication 1, où un processus de gravure de surface n'est pas appliqué au premier fil (253a).

11. Procédé de fabrication d'un substrat (200) pour l'emballage d'un composant électronique avec une couche métallique à motifs, ledit procédé comprenant :
un premier processus de préparation d'un substrat en verre (21) où un trou traversant (23) est disposé ;
un deuxième processus de formation d'une deuxième couche de redistribution supérieure (257) sur le substrat en verre (21), et
un troisième processus de formation d'une première couche de redistribution supérieure (253) sur la deuxième couche de redistribution supérieure (257),
où :
la première couche de redistribution supérieure (253) comprend un premier fil (253a) ayant un premier motif prédéterminé et une première épaisseur (d1u), et
la deuxième couche de redistribution supérieure (257) comprend un deuxième fil (257a) ayant un deuxième motif prédéterminé et une deuxième épaisseur (d2u),
le premier processus comprend :
un premier sous-processus de formation du premier fil (253a) avec le premier motif prédéterminé et la première épaisseur (d1u) par mise en œuvre d'un processus de placage, la première épaisseur (d1u) du premier fil (253a) étant comprise entre environ 1 µm et environ 5 µm ;
un deuxième sous-processus de traitement de la couche primaire sur une surface du premier fil (253a) ; et
un troisième sous-processus de comblement des espaces entre les premiers fils (253a) respectifs par un matériau isolant,
où la première épaisseur (d1u) est inférieure à la deuxième épaisseur (d2u), et
w1p est la longueur entre un pic de rugosité d'une première surface latérale du premier fil (253a) et un pic de rugosité d'une deuxième surface latérale dans la section transversale du premier fil (253a),
w1v est la longueur entre un creux de rugosité de la première surface latérale du premier fil (253a) et un creux de rugosité de la deuxième surface latérale dans la section transversale du premier fil (253a), et
le rapport entre la longueur w1v et la longueur w1p est compris entre 0,8 et 1,0.

12. Procédé de fabrication selon la revendication 11, où un processus de gravure n'est pas effectué sur les surfaces des fils pour augmenter la rugosité de surface des fils (24).

13. Procédé de fabrication selon la revendication 11, où le premier fil (253a) est un fil de cuivre ne contenant pas de cuivre à grains en forme de colonnes.

14. Procédé de fabrication selon la revendication 11, où un traitement primaire lors du deuxième sous-processus est effectué avec un composé imidazole ou un composé silane.

15. Emballage de composant électronique (900), comprenant :
le substrat (200) selon la revendication 1; et un composant monté sur le substrat (200) pour emballage.
